Europäisches Patentamt

European Patent Office

Office européen des brevets

(11) Publication number: **0 265 077**
**A2**

## (12) EUROPEAN PATENT APPLICATION

(21) Application number: **87308329.9**

(22) Date of filing: **21.09.87**

(51) Int. Cl.⁴: **H01L 23/48** , H01L 21/60

The title of the invention has been amended (Guidelines for Examination in the EPO, A-III, 7.3).

(30) Priority: **25.09.86 US 911342**

(43) Date of publication of application:
**27.04.88 Bulletin 88/17**

(84) Designated Contracting States:
**DE FR GB IT**

(71) Applicant: **Sheldahl, Inc.**

**Northfield Minnesota 55057(US)**

(72) Inventor: **Gilleo, Kenneth B.**
**806 Highland**
**Norhfield Minnesota 55057(US)**

(74) Representative: **MacGregor, Gordon et al**
**ERIC POTTER & CLARKSON 14 Oxford Street**
**Nottingham, NG1 5BP(GB)**

(54) **An anisotropic adhesive for bonding electrical components.**

(57) An anisotropic adhesive for bonding electrical components includes a plurality of fusible, electrically conductive particles dispersed uniformly throughout a thermoplastic resin. With the adhesive in a layer between two components to be joined, pressure is applied, along with heat sufficient to soften the resin, to expose particles positioned between opposed terminals whereby the exposed particles contact their associated terminals. Heat is again applied, in an amount sufficient to fuse the exposed conductive particles, thus to form a series of highly conductive mechanical bonds between pairs of opposed terminals of the joined components.

*Fig. I*

# ANISOTROPIC ADHESIVE

This invention relates to adhesives for electrically and mechanically bonding electrical circuit components, particularly integrated circuit components.

The formation of integrated circuits is well known, and applications for use of integrated circuits are virtually without limit. continued and successful efforts to reduce the size of integrated circuit packages give rise to the corresponding need for miniaturized connection of these packages, to one another or to circuit boards. Individual soldering of mating contacts becomes increasingly difficult with reduced size, and the increased use of automatic manufacturing calls for connection techniques more hospitable to automatic manufacturing tooling.

One approach to interconnecting integrated circuit components is the automatic wire bonding of individual contacts. Although rapid compared to hand soldering, such bonding is time consuming and requires expensive equipment due to the need for precision alignment. Alternatively, an electrically conductive adhesive sheet is positioned between two circuit devices for their electrical and mechanical connection. A problem with such sheets, particularly when used with components having multiple, discrete contacts, is that they must be anisotropic, i.e. able to conduct electricity across their thickness, but effectively insulate in directions normal to the conductive paths.

One such conductor is shown in US-A-3,541,222 (Parks). A dielectric sheet, for example of epoxy, is provided with multiple spherical connector elements. The elements are embedded in the sheet, but protrude from both sides of it to form a connector screen used to connect circuit boards or modules. Another connector is shown in US-A-3,680,037 (Nellis) showing an interconnector including a sheet of dielectric material provided with multiple through holes. Conductive, plastic elements are then compressed slightly and fit into the through holes. Such can be satisfactory but become impracticable as reductions in component size lead to closer spacing between adjacent contacts.

To meet the requirements of smaller sized components, a substantially homogeneous, anisotropic adhesive is shown in US-A-4,113,981 (Fujita). Spherical conductive particles are distributed throughout a nonconductive base. The mechanical connection between components depends upon the adhesive properties of the base. Because the sheet of Fujita is homogeneous, improvement of conductivity through the sheet thickness necessarily decreases the insulative capability along the length and width of the sheet. Thus, to "fine tune" the properties of the sheet, Fujita teaches the addition either of scale-like conductive particles, or of insulative particles.

A similar known approach is to incorporate conductive fibers into an insulative sheet. Improved chip designs utilize low voltages but relatively high current, limiting the use of homogeneous adhesive sheets. Further, expansion and contraction of the adhesive affects conductivity.

Therefore, it is an object of the present invention to provide an anisotropic adhesive having a high conductivity over portions of the adhesive lying directly between contacts of opposed circuit components.

Another object of the invention is to provide an interconnection between two circuit components in which an originally homogeneous connecting structure is selectively altered to provide high conductivity between opposed and aligned terminal contacts of the respective components.

Another object is to provide a comparatively simple and low cost method of manufacturing an interconnection of two or more circuit components.

Yet another object of the invention is to provide a method for manufacturing an assembly of two or more circuit components, which permits testing of the assembly for proper component alignment prior to altering a homogeneous adhesive layer at selected locations.

A further object of the invention is to provide an anisotropic adhesive which permits the simultaneous connection of multiple, closely adjacent contacts of a circuit component to opposed contacts of a corresponding circuit component.

To achieve these and other objects, there is provided an interconnection of two electrical circuit components. The interconnection includes a first circuit component having a first surface and a plurality of spaced apart first electrical contacts on the first surface. The interconnection further includes a second circuit component having a second surface and a plurality of spaced apart second electrical contacts on the second surface. A connecting means joins the first and second circuit components with the first and second surfaces facing each other and spaced apart, with at least selected ones of the second contacts aligned with associated first contacts to form pairs of opposed first and second contacts. The connecting means includes a dielectric medium between and contiguous with the first and second surfaces, and a plurality of fusible, electrically conductive particles dispersed substantially uniformly throughout the medium. Some of the particles form particle sets, with the particles in each set being at least substantially aligned with an associated contact pair, and fused to form a mechanical and electrical connection between the first and second contacts of the associated contact pair.

Another aspect of the present invention is an interconnection of first and second circuit components in which the interconnecting layer is created by applying to one such component a liquid mixture including the dielectric medium, the particles and a solvent, then drying to substantially remove the solvent.

Yet another aspect of the present invention is a process for connecting first and second electrical circuit components including the steps of:

(a) forming an interconnecting mixture including a dielectric medium, a plurality of fusible, electrically conductive particles dispersed substantially uniformly throughout said medium, and a solvent;

(b) applying the interconnecting mixture over a first surface of a first circuit component, thereby to cover a plurality of spaced apart first electrical terminals on the first surface;

(c) drying the mixture to form an interconnecting layer including the particles dispersed substantially uniformly and in spaced apart relation in the medium;

(d) providing a second circuit component having a second surface and a plurality of spaced apart second electrical terminals on the second surface, and maintaining the second surface against the interconnecting layer and facing the first surface, while aligning at least selected ones of the second terminals with associated first terminals to form pairs of opposed first and second terminals;

(e) applying heat to the interconnecting layer to raise its temperature to a first value to deform the medium whereby individual sets of the particles, each set consisting of particles at least substantially aligned between an associated pair of the first and second terminals, contact the terminals of their associated terminal pairs; and

(f) applying heat to the interconnecting layer to raise its temperature to a second value greater than the first value, thus to melt the particles and fuse each of the sets into a mechanical and electrical connection between its associated first and second electrical terminals.

This process can, if desired, include a further step of electrically testing the connected components, following heating to the first temperature value but prior to fusion of the particle sets. In this manner problems such as misalignment between the circuit components or faulty individual contacts or terminals can be identified before the selected particles have been permanently altered.

The conductive particles are preferably spherical and have a generally uniform diameter, for example a maximum of 44 microns and minimum of under 1 micron. This permits simultaneous connection of a multiplicity of terminal contacts with very little separation between adjacent contacts, as is required by many smaller integrated circuit packages. The fused particles joining contacts of each pair ensure high conductivity between the contacts and form part of the mechanical bond between the circuit components. At the same time, the non-fused particles retain their spherical shape and are surrounded by the dielectric medium, and thus are electrically isolated from one another to prevent unintended conduction or arcing between adjacent contacts.

Reference is made to the accompanying drawings in which:

Figure 1 is a front cross-sectional view showing an interconnection of an integrated circuit device and circuit board in accordance with the present invention;

Figure 2 is a perspective view of an IC chip, flexible tape circuitry, and an adhesive layer formed in accordance with the present invention, prior to their interconnection;

Figures 3-6 are schematic views illustrating the connecting of the chip and the flexible tape circuitry of Figure 2; and

Figure 7 is a schematic view illustrating an alternative step in the connecting process of Figures 3-6.

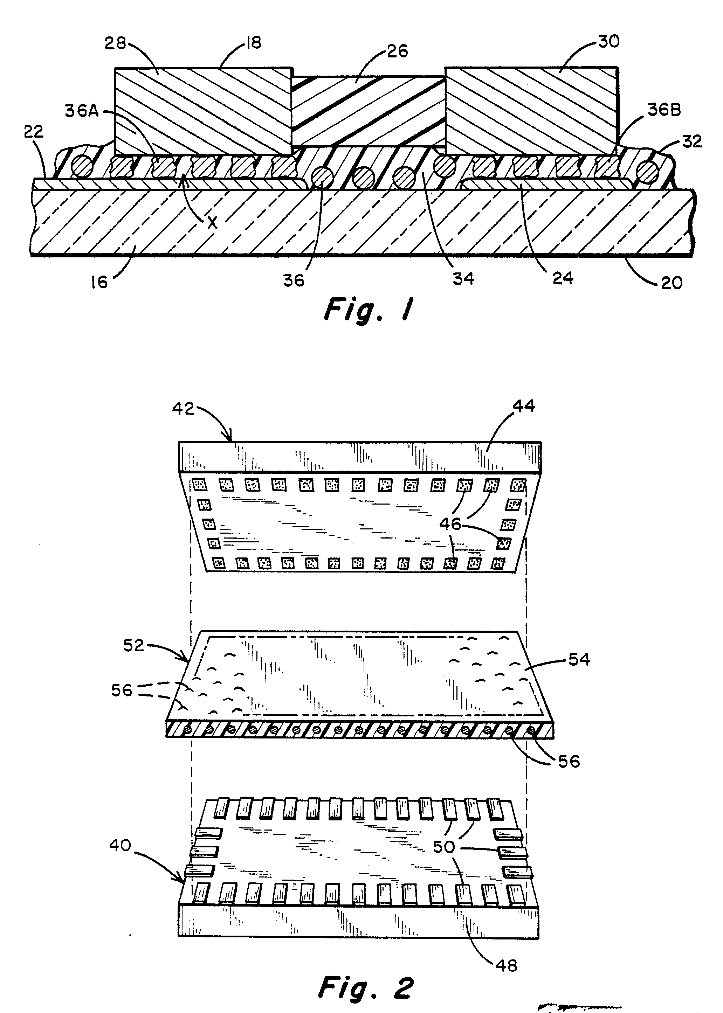

Turning now to the drawings, there is shown in Figure 1 an interconnection of two circuit components, with a first component or printed circuit board 16 joined to a second component or integrated circuit device 18. Circuit board 16 includes an electrically insulative substrtate 20, on which is formed an electrically conductive circuit pattern including circuit board contacts 22 and 24. Device 18 is a surface mounted component or device (SMD) having a central body 26 and terminals or contacts 28 and 30 formed on opposite ends of the body. The contacts completely surround the ends of the device to eliminate the need for placing it in a particular orientation as it is connected to circuit board 16, an advantage in automated manufacturing processes. Materials used to form such contacts include gold, silver and solder coating or plating, and nickel.

Between device 18 and circuit board 16 is an interconnection layer of an adhesive 32 which bonds the chip and circuit board together. Adhesive 32 includes a dielectric medium in the form of a thin film 34, and a plurality of electrically conductive particles 36 spaced apart from one another and dispersed uniformly throughout film 34. Particles 36 are all substantially the same size, and initially are all spherical in shape, like the particles between circuit board 16 and central body 26.

Particles aligned with and between opposed contacts, however, have an irregular shape, as shown at 36A for a first set of particles between contacts 22 and 28, and at 36B for a second set of particles lying between contacts 24 and 30. The irregular shape of particles 36A and 36B arises from the fact that during manufacture of the interconnection between the circuit board and device, all of particles 36 are heated to a temperature above their melting point and undergo fusion. As a result, particles 36A and 36B wet the surfaces of their associated contacts to form solder-like electrical and mechanical connections between the associated contacts. Film 34 tends to remain between adjacent particles as indicated at "X". Particles 36, though similarly subjected to high temperatures, are relatively remote from any wettable surface. Due to normal surface energy, they retain their spherical shape and remain electrically isolated.

Preferably dielectric film 34 is a polyester film, for example a thermoplastic having heat-activated adhesive properties, enabling it to form a bond between circuit board 16 and device 18. Such films typically have softening points in the range of from 90° C. to 150° C., and melting points tending to be from 20° C. to 40° C. above the softening points.

Thermoset resins, for example certain epoxy or modified epoxy resins, also can be used as the dielectric film and, compared to thermoplastic films, have stronger bonding characteristics. On the other hand, their cure time tends to be much longer. Consequently, an important feature of the present invention resides in the fact that by establishing fusion bonds between opposed pairs of contacts, the bonding ability of the dielectric film becomes less critical, thus increasing the number of applications suitable for thermoplastic resins.

Particles 36 preferably are of a metal having a melting point sufficiently low to permit fusion bonding without degrading contacts or surrounding material. These particles also should form solder-type connections without requiring flux. Suitable metals for particles 36 include alloys of tin, lead, bismuth, indium, and cadmium. Other metals suitable for soldering may be appropriate in particular applications. The diameter of particles 36 preferably is substantially equal to, but less than the average thickness of dielectric film 34. More particularly, it has been found advantageous to size particles 36 so that their dispersion tends to form a single layer of particles in the film, and with little or no protrusion of particles beyond the film surface. Nonetheless, where terminal contacts protrude from the facing surfaces of their associated circuit components, the components may be joined using an adhesive with a particle diameter substantially less than nominal film thickness. The principal requirement is compression of the adhesive between opposed contacts, sufficient to bring discrete particles together for fusion and wetting of the contacts.

Figure 2 shows a pair of circuit components, a portion of flexible printed wiring (FPW) or tape circuitry 40 and an integrated circuit chip 42, positioned for interconnection into a single assembly. Chip 42 includes a dielectric body 44 such as a ceramic, with a plurality of contact pads 46 distributed about the chip surface and extending beyond the top and bottom surfaces of the chip, although only the bottom surface is visible in the figure.

Flexible tape circuitry 40 includes a dielectric base 48, e.g. of polyimide, and a metallized circuit pattern 50 formed on the base. An anisotropic adhesive sheet 52 is positioned between the circuit components.

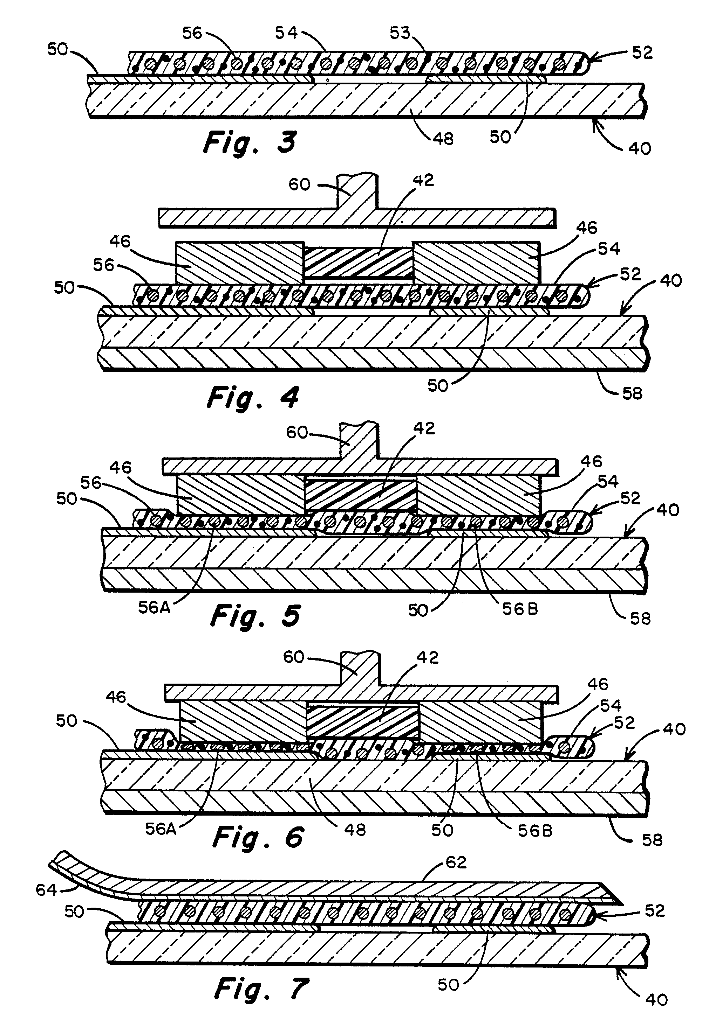

The bonding of these components into a connected assembly is explained in connection with Figures 3-6. First, an anisotropic mixture in liquid form is created by blending together a thermoplastic or thermoset resin, a metal powder comprised of conductive particles, and a solvent. If desired, non-fusible, non-conductive (i.e. insulating) particles 53, smaller in diameter than the conductive particles, can be added to reduce the chances of adjacent conductor particles contacting one another. The resin should be dissolved in the solvent to provide a coatable or printable material. This is achieved with a mixture of up to fifty percent, by weight, a polar solvent such as methylene chloride.

The anisotropic liquid mixture then is applied directly to flexible tape circuitry 40, to cover circuit pattern 50 and the surrounding surface as shown in Figure 3. The solvent is permitted to evaporate, preferably slowly, to form sheet 52, a dry, essentially bubble-free dielectric film 54 in which spherical, electrically conductive fusible particles 56 and insulative particles 53, are uniformly distributed and spaced apart from each other.

IC chip 42 is then positioned over flexible tape circuitry 40 and against the top surface of adhesive sheet 52 as shown in Figure 4. Flexible circuitry 40 lies on a platform 58 through which heat is supplied to the components. A vertically reciprocable vacuum chuck, the lower portion of which is shown at 60 in the figure, vertically reciprocates and can be lowered to maintain chip 42 against the adhesive sheet. Alternatively, when components are attached to the top of a circuit board, heat is preferably applied from above the circuit board, along with pressure.

With vacuum chuck 60 lowered in a controlled fashion, platform 58 is heated to heat adhesive sheet 52, preferably to a temperature above the softening point of dielectric film 54, but below the melting point of particles 56. The result is the configuration shown in Figure 5, where all of particles 56 remain in the spherical shape. Dielectric film 54, becoming malleable upon reaching the softening temperature, is deformed responsive to pressure from vacuum chuck 60, particularly in the regions between opposed contacts, to expose particles 56A and 56B so that they contact the surfaces of pads 46 and circuit pattern 50.

At this point, the assembly may be subjected to electrical testing if desired, to ensure proper connections between all contacts prior to any fusion of particles 56. Such testing can identify problems such as misalignment between the contacts of chip 42 and circuit pattern 50, so that a misalignment may be corrected prior to fusion. Alternatively, a fault in chip 42 or flexible circuitry 40 may be discovered at this juncture, and the faulty component repaired or replaced.

Following testing, the assembly is heated once again, this time an increased amount so that the temperature of adhesive sheet 52 reaches a level above the melting point for particles 56. Particles 56A and 56B wet the surfaces of pads 46 and circuit pattern 50, and re-flow out of the circular shape to form a solder-like mechanical and electrical connection between the opposed contact surfaces, as shown in Figure 6. Particles 53, being non-fusible, retain their spherical shape and can positively control the spacing between pads 46 and circuit pattern 50. This process is suitable, as well, for joining two substantially rigid components.

One advantage of the present invention resides in the fact that dielectric film 54 substantially surrounds particles 56, so that the particles are not exposed to the atmosphere until just before they contact their associated pads and circuitry and are fused. Thus, particles 56 may be formed of alloys having a tendency to oxidize when exposed to the atmosphere, since the particles can be protected from such exposure until fusion is imminent. The tendency of oxidation to inhibit a good soldered connection is minimized or eliminated.

Figure 7 illustrates an alternative method of applying adhesive sheet 52 to flexible circuitry 40. Particles 53, though not illustrated, can be added if desired. The liquid mixture is applied to a transfer sheet 62, following the application of a release layer 64 to the transfer sheet. Drying is accomplished with the mixture mounted on the transfer sheet, thus to form an interim assembly of adhesive sheet 52 on the transfer sheet. The interim assembly then is placed on flexible tape circuitry 40, with the adhesive layer lying against circuit pattern 50 and the surrounding surface. Then, heat is supplied in sufficient amount to activate the release layer, leaving adhesive sheet 52 mounted on flexible tape circuitry 40 after removal of transfer sheet 62. Beyond this state, the remaining steps of the process are as above explained. As an alternative, the interim assembly could be placed against the bottom of chip 42.

As one example, a eutectic alloy of 44 percent indium, 42 percent tin, and 14 percent cadmium, all weight percentages, is suitable for fusible particles 56. The eutectic melting point is 93° C., sufficiently low for compatibility with most thermoplastic materials such as polyesterfilm. This alloy is available from Indium Corporation as "Alloy No. 8".

Another alloy suitable for fusible particles consists of 52 percent indium and 48 percent tin. This is a eutectic alloy having a melting point of 118° C., with very good wetting characteristics.

An example of resin suitable for the medium in both of these examples is a thermoplastic available as "Resin 49029" from E.I. DuPont deNemours & Company. Whatever the resin selected, it must be capable of softening to allow the conductive particles to come into contact with terminals, contact pads or the like for subsequent fusion bonding, and must not react with the conductive particles.

Component assemblies formed in accordance with the above described process provided very low ohmic connections. Also, since conductive particles not located between contacts retain their spherical shape and electrical isolation, there is no unwanted conduction of electricity laterally along the adhesive. Because it provides for selective fusion of initially homogeneous conductive particles, the adhesive enables use of simpler, lower cost automatic bonding equipment. There is no need for individually completing each connection, an advantage that becomes increasingly important as the size of components is reduced. Further, the fusion creates a strong mechanical bond between opposed contacts of the electrical components. This can reduce the need for strong adhesive qualities in the medium supporting the conductive particles, for example allowing the use of a thermoplastic resin rather than a thermoset resins. Alternatively, conductive particle fusion enhances resin bonding, to provide a connection that remains stable even when subjected to high vibration, shock or other disturbances in physically demanding environments.

## Claims

1. An interconnection of two electrical circuit components including:
a first circuit component having a first surface, and a plurality of spaced apart first electrical contacts on the first surface; a second circuit component having a second surface, and a plurality of spaced apart second electrical contacts on the second surface; and

a connecting means for joining said first and second circuit components with said first and second surfaces facing one another and spaced apart from one another, and with at least selected ones of said second contacts aligned with associated first contacts to form pairs of opposed first and second contacts;

wherein said connecting means includes a dielectric medium between and contiguous with said first and second surfaces, and a plurality of fusible, electrically conductive particles dispersed substantially uniformly throughout said medium; a portion of said particles forming particle sets, with the particles in each set being at least substantially aligned with an associated contact pair, and fused to form a mechanical and electrical connection between the first and second contacts of said associated contact pair.

2. The interconnection of Claim 1 wherein: said medium comprises an adhesive resin, and cooperates with said connections between the contacts of each associated contact pair to provide the mechanical bond between said first and second components.

3. The interconnection of Claim 2 wherein: said resin is a polyester resin.

4. The interconnection of Claim 1 wherein the mechanical bond of said first and second components is provided substantially by said connections between the contacts of said associated contact pairs.

5. The interconnection of Claim 1 wherein: said particles not included in said sets are substantially spherical and electrically isolated from one another by said medium.

6. The interconnection of Claim 5 wherein: said particles not included in said sets are substantially similar in size, and have a diameter of less than 44 microns.

7. The interconnection of Claim 1 wherein: said particles consist essentially of an alloy including at least one of the following tin, lead, bismuth, indium and cadmium.

8. The interconnection of Claim 7 wherein: said alloy is a eutectic alloy.

9. An interconnection of two electric circuit components including:
a first circuit component having a first surface and a plurality of spaced apart first electrical contacts on said first surface;
an interconnecting layer on said first surface and formed from a liquid mixture including a dielectric medium, a plurality of fusible, electrically conductive particles dispersed substantially uniformly throughout said medium, and a solvent, said mixture applied to said first surface and cured to form said interconnecting layer, said layer including said medium and a substantially uniform dispersion of said particles, in spaced apart relation, throughout said medium;

a second circuit component having a second surface and a plurality of second spaced apart electrical contacts on said second surface, said second surface facing said first surface, contiguous with said interconnecting layer, and with at least selected ones of said second contacts aligned with associated first contacts to form pairs of opposed first and second contacts; and

wherein a portion of said particles form discrete sets of particles, each set consisting of particles at least substantially aligned between an associated pair of said first and second contacts, and fused to form a mechanical and electrical connection between said associated pair of contacts.

10. The interconnection of Claim 1 wherein: said particles comprise from ten to fifty percent, by weight, of said connecting layer.

11. The interconnection of Claim 1 including: a plurality of non-fusible, electrically insulative particles smaller in diameter than said electrically conductive particles, dispersed substantially uniformly throughout said medium.

12. The interconnection of Claim 11 wherein: the diameter of said electrically insulative particles is substantially equal to the distance between the first and second contacts of each said pair.

13. The interconnection of Claim 9 wherein: said solvent comprises up to fifty percent, by weight, of said liquid mixture.

14. The interconnection of Claim 9 wherein: said solvent consists essentially of methylene chloride.

15. The interconnection of Claim 9 wherein: said liquid mixture further includes a plurality of substantially non-fusible, electrically non-conductive particles dispersed substantially uniformly throughout said medium and substantially smaller in diameter than said electrically conductive particles.

16. A process for connecting first and second electrical circuit components, including the steps of:

(a) forming an interconnecting mixture including a dielectric medium, a plurality of fusible, electrically conductive particles dispersed substantially uniformly throughout said medium, and a solvent;

(b) applying said interconnecting mixture over a first surface of a first circuit component, thereby to cover a plurality of spaced apart first electrical terminals on said first surface;

(c) drying said mixture to form an interconnecting layer including said particles dispersed substantially uniformly and in spaced apart relation in said medium;

(d) providing a second circuit component having a second surface and a plurality of spaced apart second electrical terminals on said second surface, and maintaining said second surface against said interconnecting layer and facing said first surface, while aligning at least selected ones of said second terminals with associated first terminals to form pairs of opposed first and second terminals;

(e) increasing the temperature of said interconnecting layer a first value to deform said medium whereby individual sets of said conductive particles, each set consisting of particles at least substantially aligned between an associated pair of said first and second terminals, contact the terminals of their associated terminal pairs; and

(f) further increasing the temperature of said interconnecting layer to a second value greater than said first value, to melt said conductive particles and thereby fuse each of said sets into a mechanical and electrical connection between its associated first and second electrical terminals.

17. The process of Claim 16 wherein:
the step of applying said interconnecting mixture over a first surface of a first circuit device includes the steps of:

(a) applying said mixture in liquid form to a release-coated transfer sheet;

(b) drying said mixture to form said interconnecting layer on said transfer sheet;

(c) pressing said layer and transfer sheet against said first surface, with said interconnecting layer contiguous with said first surface, and applying heat to said interconnecting layer and transfer sheet; and

(d) removing said transfer sheet from said interconnecting layer.

18. The process of Claim 16 wherein:
the step of applying heat to said interconnecting layer to raise its temperature to a first value further includes the step of simultaneously applying a selected pressure against said second component to controllably urge said second surface against said interconnecting layer.

19. The process of Claim 18 wherein:
said first electrical component includes flexible tape circuitry, and said second electrical component includes an integrated circuit chip positioned above said circuitry; said heat being applied from below said circuitry, while said pressure is applied from above said chip.

20. The process of Claim 16, including:
the further step of performing an electrical test on said electrical components following the step of increasing the temperature of said interconnecting layer to said first value, and before the step of further increasing the temperature of said interconnecting layer to said second value.

21. The process of Claim 16 wherein:
said solvent is a polar solvent.

22. The process of Claim 21 wherein:
said solent consists essentially of methylene chloride.

23. The process of Claim 16 wherein:
said medium is a resin wuith heat-activated adhesive properties.

24. The process of Claim 16 wherein:
said solvent includes up to fifty percent, by weight, of said mixture, and wherein said particles, after the curing of said mixture, comprise from ten to fifty percent, by weight, of said interconnecting layer.

25. The process of Claim 16 wherein:
said interconnecting mixture further includes a plurality of non-fusible, electrically non-conductive particles smaller in diameter than said conductive particles and dispersed substantially uniformly throughout said dielectric medium.

26. The process of Claim 25 wherein:
the step of applying heat to said interconnecting layer to raise its temperature to a first value, and the step of further increasing the temperature of said interconnecting layer to said second value, further include the step of simultaneously applying pressure against said secnd component to controllably urge said second surface against said interconnecting layer; wherein pluralities of said non-conductive particles, positioned between said pairs of first and second terminals, limit travel of the terminals of each said pair towards one another responsive to said pressure.

27. An anisotropic adhesive for connecting electrical circuit components, including:
a thin dielectric film; and a plurality of fusible electrically conductive particles dispersed substantially uniformly throughout said medium, substantially uniform in diameter, and spaced apart from one another; and
wherein at least some of said fusible particles are comprised of particle sets, with the particles in each set being fused and in contact with an associated first terminal of a first electrical circuit component, and an associated second terminal of a second electrical circuit component.

28. The anisotropic adhesive of Claim 27 further including:
a plurality of non-fusible, electrically insulative particles dispersed substantially uniformly throughout said medium and having a diameter less than that of said conductive particles.

30. The adhesive of Claim 27 further including: a plurality of non-fusible, electrically insulative particles dispersed substantially uniformly throughout said medium and having a diameter less than that of said conductive particles, with certain particles of said plurality of said non-fusible particles in contact with said first and second terminals, thereby to determine a spacing between said first and second terminals in accordance with the diameter of said certain particles.

**Fig. 1**

**Fig. 2**

Fig. 3

Fig. 4

Fig. 5

Fig. 6

Fig. 7